(19) Europäisches Patentamt
European Patent Office
Office européen des brevets

(11) **EP 3 462 188 B1**

(12) **FASCICULE DE BREVET EUROPEEN**

(45) Date de publication et mention
de la délivrance du brevet:
**16.09.2020 Bulletin 2020/38**

(51) Int Cl.:
**G01R 23/00** *(2006.01)*          **G01R 23/16** *(2006.01)*
**G01R 31/317** *(2006.01)*

(21) Numéro de dépôt: **18197119.3**

(22) Date de dépôt: **27.09.2018**

(54) **PROCEDE DE DETERMINATION DU FACTEUR DE QUALITE D'UN OSCILLATEUR**

VERFAHREN ZUR BESTIMMUNG DES QUALITÄTSFAKTORS EINES OSZILLATORS

METHOD FOR DETERMINING THE QUALITY FACTOR OF AN OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.09.2017 FR 1759009**

(43) Date de publication de la demande:
**03.04.2019 Bulletin 2019/14**

(73) Titulaire: **Commissariat à l'Energie Atomique et aux Energies Alternatives**
**75015 Paris (FR)**

(72) Inventeurs:
• **NOWODZINSKI, Antoine**
  **38134 SAINT JOSEPH DE RIVIERE (FR)**
• **SOUCHON, Frédéric**
  **69003 LYON (FR)**

(74) Mandataire: **Cabinet Camus Lebkiri**
**25 rue de Maubeuge**
**75009 Paris (FR)**

(56) Documents cités:
**US-B1- 8 686 802**

• **WEN-MING ZHANG ET AL: "Nonlinear Dynamic Analysis of Electrostatically Actuated Resonant MEMS Sensors Under Parametric Excitation", IEEE SENSORS JOURNAL, IEEE SERVICE CENTER, NEW YORK, NY, US, vol. 7, no. 3, 1 mars 2007 (2007-03-01), pages 370-380, XP011163489, ISSN: 1530-437X**
• **ALI H NAYFEH ET AL: "Dynamics of MEMS resonators under superharmonic and subharmonic excitations", JOURNAL OF MICROMECHANICS & MICROENGINEERING, INSTITUTE OF PHYSICS PUBLISHING, BRISTOL, GB, vol. 15, no. 10, 1 octobre 2005 (2005-10-01), pages 1840-1847, XP020091372, ISSN: 0960-1317, DOI: 10.1088/0960-1317/15/10/008**
• **HASSEN M. OUAKAD ET AL: "The dynamic behavior of MEMS arch resonators actuated electrically", INTERNATIONAL JOURNAL OF NON-LINEAR MECHANICS, vol. 45, no. 7, 1 septembre 2010 (2010-09-01), pages 704-713, XP055415795, AMSTERDAM, NL ISSN: 0020-7462, DOI: 10.1016/j.ijnonlinmec.2010.04.005**

**EP 3 462 188 B1**

**Description**

**DOMAINE TECHNIQUE DE L'INVENTION**

La présente invention concerne un procédé de détermination du facteur de qualité d'un oscillateur.

**ARRIERE-PLAN TECHNOLOGIQUE DE L'INVENTION**

Un oscillateur à actionnement électrostatique de type microsystème ou nanosystème électromécanique, respectivement MEMS (« microelectromechanical system » en anglais) ou NEMS (« nanoelectromechanical system » en anglais), est un dispositif comprenant un élément mobile pouvant être mis en oscillation.

De tels oscillateurs consomment peu d'énergie et présentent un encombrement réduit. Ils trouvent donc une application particulièrement avantageuse dans des objets nomades tels que des téléphones intelligents (smartphones) ou des tablettes numériques. Ces oscillateurs sont en particulier utilisés pour fabriquer des capteurs inertiels, comme des accéléromètres ou des gyromètres, destinés à équiper de tels objets.

Un objet nomade peut par ailleurs être équipé d'un système de localisation par satellite (GPS pour « Global Positionning System » en anglais) qui consomme beaucoup d'énergie. Les capteurs inertiels permettent de calculer en temps réel les déplacements de l'objet et donc de réduire le recours au système de localisation par sattellite. Ce dernier reste cependant utile pour déterminer une position de référence de l'objet, par exemple à des intervalles de temps réguliers.

L'oscillateur à actionnement électrostatique comporte des moyens d'actionnement qui transforment un signal d'excitation appliqué en entrée de l'oscillateur en une force d'actionnement électrostatique, également appelée « force d'excitation », agissant sur l'élément mobile. Les déplacements de l'élément mobile sont mesurés par des moyens de détections qui génèrent un signal de réponse en sortie de l'oscillateur. Le signal d'excitation et le signal de réponse se présentent par exemple sous la forme de tensions.

L'oscillateur est notamment caractérisé par un facteur de qualité qui est un paramètre influant sur la précision du capteur inertiel. Un oscillateur avec un facteur de qualité élevé permet d'obtenir un capteur inertiel plus précis, ce qui permet de recourir moins fréquemment au système de localisation par satellite et donc de réduire la consommation d'énergie électrique.

Il est donc important de mesurer le facteur de qualité de l'oscillateur, notamment pour valider le développement et la fabrication du capteur inertiel.

Une première méthode de mesure du facteur de qualité consiste à exciter l'oscillateur au moyen d'une tension d'excitation sinusoïdale de fréquence $F_0$ et à mesurer l'amplitude des oscillations à la fréquence 2Fo. L'amplitude des oscillations est mesurée à la fréquence 2Fo car la force d'actionnement électrostatique est proportionnelle au carré de la tension d'excitation. En balayant une plage de fréquence, on obtient une densité spectrale d'amplitude des oscillations qui comprend un pic de résonance présentant un maximum d'amplitude atteint à la fréquence de résonance de l'oscillateur. Le facteur de qualité peut alors être déterminé à partir de la largeur du pic de résonance considérée à la moitié de sa hauteur.

Un inconvénient de cette méthode de mesure par balayage en fréquence est que pour mesurer correctement l'amplitude des oscillations, l'oscillateur doit retrouver une position de repos entre deux mesures successives. Le temps nécessaire pour que l'oscillateur retrouve sa position de repos après excitation est approximativement égal à trois fois une constante d'amortissement qui est proportionnelle au facteur de qualité. En considérant par exemple un facteur de qualité de l'ordre de $10^6$, la constante d'amortissement est de l'ordre de 10 secondes. Dans ce cas, il faut par exemple plus de 2 heures pour acquérir 250 points de mesure.

Par ailleurs, la précision avec laquelle le pic de résonance est défini dépend du nombre de points de mesure. Si le nombre de points n'est pas suffisant, le pic de résonance peut être élargi artificiellement et son maximum d'amplitude peut être décalé en fréquence, ce qui fausse la mesure du facteur de qualité.

Le temps nécessaire pour mettre en œuvre cette méthode de mesure est donc un facteur limitant la productivité, d'autant plus que la tendance actuelle est à l'augmentation du facteur de qualité des oscillateurs. Ce temps de mesure ne permet raisonnablement pas, en particulier d'un point de vue industriel, de caractériser tous les oscillateurs d'une plaque de silicium qui en comporte généralement plus d'une centaine. Seuls quelques oscillateurs sont alors caractérisés, ce qui rend difficile d'estimer un rendement de fabrication des oscillateurs.

Le document de Wen-Ming Zhang et al., "Nonlinear Dynamic Analysis of Electrostatically Actuated Resonant MEMS Sensors Under Parametric Excitation", IEEE Sensors Journal, vol. 7, no. 3, 1 mars 2007 (2007-03-01), pages 370-380, divulgue une méthode d'analyse dynamique non linéaire d'un oscillateur MEMS dans laquelle une tension d'excitation, résultant de la somme d'une tension continue et d'une tension sinusoïdale, est générée et appliquée à l'entrée de l'oscillateur. Ce document montre l'effet de la variation de la tension continue et de l'amplitude de la tension sinusoïdale sur les caractéristiques de l'oscillateur telles que la fréquence de résonance.

2

Le facteur de qualité peut également être déterminé par une mesure du décrément logarithmique de l'amplitude des oscillations de l'oscillateur. Cette méthode de mesure consiste à appliquer un signal d'excitation en entrée de l'oscillateur puis à acquérir le signal de réponse présent en sortie de l'oscillateur après avoir arrêté l'excitation de l'oscillateur.

La mesure du décrément logarithmique peut être effectuée en utilisant comme signal d'excitation une tension sinusoïdale à la fréquence de résonance. Dans ce cas, un inconvénient est qu'il est nécessaire de paramétrer la fréquence de la tension sinusoïdale avec précision. En effet, si la fréquence de la tension sinusoïdale s'écarte trop de la fréquence de résonance, l'amplitude des oscillations risque d'être trop faible pour permettre une mesure correcte.

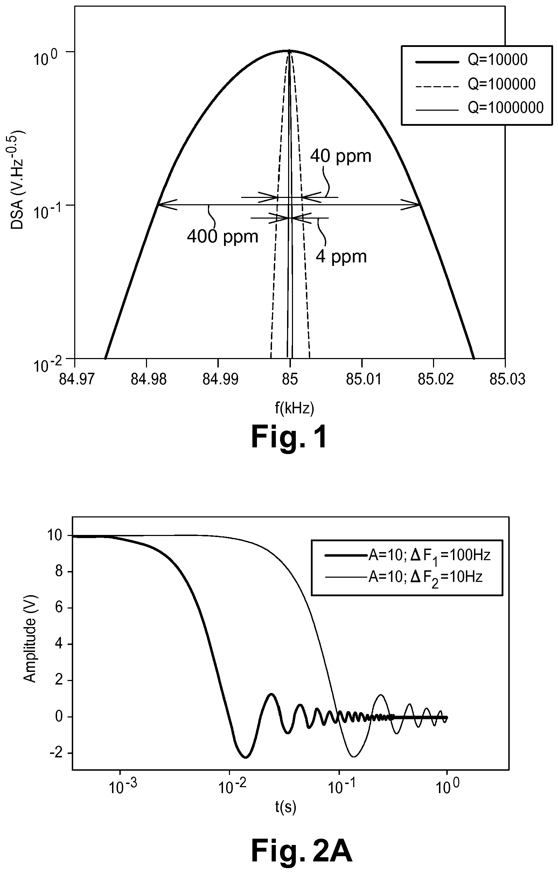

La figure 1 illustre la relation qui existe entre le facteur de qualité et la précision requise pour régler la fréquence du signal d'excitation. La figure 1 représente la densité spectrale d'amplitude (DSA) de la tension de réponse de trois oscillateurs dont la fréquence de résonance est égale à 85 kHz et dont le facteur de qualité Q est respectivement égal à $10^4$, $10^5$ et $10^6$. On considère la largeur spectrale $\Delta F$ du pic de résonance lorsque l'amplitude est divisée par un facteur 10 par rapport au maximum d'amplitude. Cette largeur spectrale $\Delta F$, qui représente la tolérance sur la valeur que peut prendre la fréquence du signal d'excitation, est environ égale à 400, respectivement 40 et 4, parties par million de la fréquence de résonance lorsque le facteur de qualité est égal à $10^4$, respectivement $10^5$ et $10^6$.

Un autre inconvénient est que la fréquence de résonance de l'oscillateur varie en fonction des conditions expérimentales, notamment en fonction de la température et du montage pour la mesure. La variation de la fréquence de résonance peut atteindre 5000 parties par million. Par conséquent, il est nécessaire de rechercher la fréquence de résonance avant chaque mesure du facteur de qualité ce qui fait perdre beaucoup de temps. De plus, lorsque la fréquence de résonance de l'oscillateur varie rapidement, il peut être difficile d'enchaîner suffisamment rapidement la localisation de la fréquence de résonance et la mesure du décrément logarithmique.

La mesure du décrément logarithmique peut également être effectuée en utilisant comme signal d'excitation une impulsion de tension. En effet, une impulsion dans le domaine temporel correspond à une amplitude constante dans le domaine fréquentielle. En pratique, l'impulsion présente plutôt une grande largeur de bande spectrale. En faisant en sorte que la fréquence de résonance de l'oscillateur soit incluse dans la largeur spectrale de l'impulsion, il est possible d'exciter l'oscillateur sans qu'il soit nécessaire de connaître précisément la fréquence de résonance.

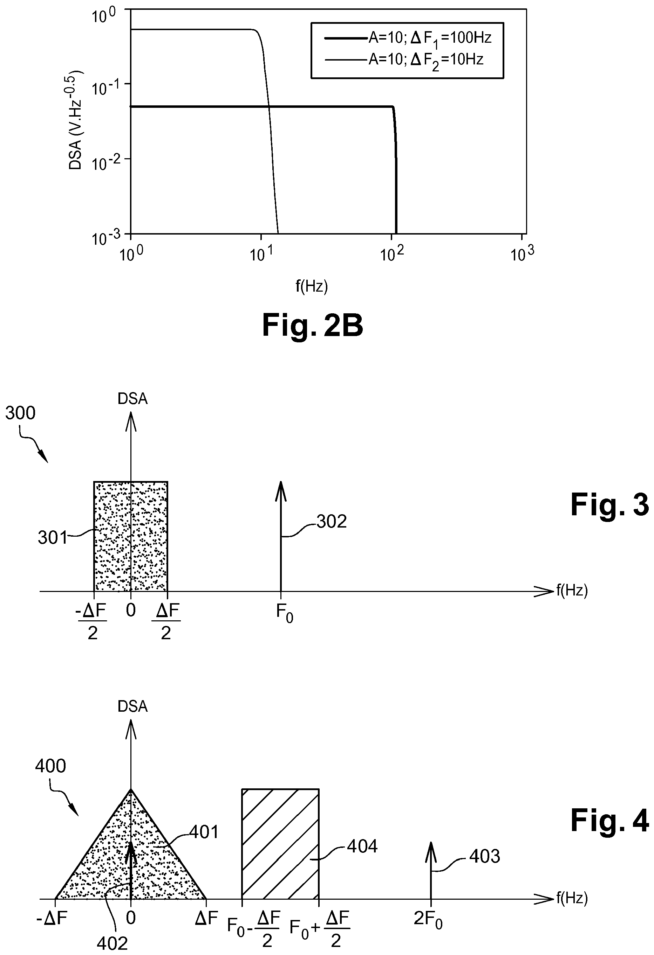

Toutefois, un inconvénient de cette méthode est que plus la fréquence de résonance de l'oscillateur est élevée, plus la densité spectrale d'amplitude du signal d'excitation est faible car la largeur spectrale du signal d'excitation doit être supérieure à la fréquence de résonance. Ce phénomène est mis en évidence sur les figures 2A et 2B.

La figure 2A montre un exemple d'une impulsion de tension se présentant sous la forme d'une fonction sinus cardinal, l'impulsion de tension u(t) étant définie par l'équation suivante :

$$u(t) = A.\operatorname{sinc}(\Delta F.t) \hspace{4cm} (1)$$

où A et $\Delta F$ sont respectivement l'amplitude et la largeur de bande spectrale du signal d'excitation. La figure 2 représente un premier signal ayant une première largeur spectrale $\Delta F_1$ de 100 Hz et un deuxième signal ayant une deuxième largeur spectrale $\Delta F_2$ de 10 Hz.

La figure 2B montre la densité spectrale d'amplitude des signaux de la figure 2A. Lorsque la largeur spectrale est multipliée par un facteur 10, la densité spectrale d'amplitude est divisée par un facteur 10. Par conséquent, si la fréquence de résonance de l'oscillateur est élevée, par exemple de l'ordre de plusieurs dizaines de kilohertz, la force électrostatique générée par l'impulsion de tension est trop faible pour exciter l'oscillateur de manière à permettre une mesure de l'amplitude des oscillations.

## RESUME DE L'INVENTION

Il ressort de ce qui précède qu'il existe un besoin de disposer d'une méthode à la fois rapide et fiable pour déterminer le facteur de qualité d'un oscillateur à actionnement électrostatique. La revendication 1 définit un procédé répondant à ce besoin. Des caractéristiques additionnelles sont définies par les revendications 2-5.

Un premier aspect de l'invention concerne un procédé de détermination d'un facteur de qualité d'un oscillateur à actionnement électrostatique, l'oscillateur présentant une fréquence de résonance, le procédé comportant les étapes suivantes :

- générer une tension d'excitation définie comme étant la somme d'une tension sinusoïdale et d'une impulsion de tension ;
- appliquer la tension d'excitation en entrée de l'oscillateur ;
- acquérir dans le domaine temporel une tension de réponse présente en sortie de l'oscillateur après avoir cessé d'appliquer la tension d'excitation en entrée de l'oscillateur ;

- déterminer le facteur de qualité de l'oscillateur à partir de la tension de réponse acquise en sortie de l'oscillateur.

L'invention permet de déterminer le facteur de qualité de l'oscillateur de manière rapide en effectuant une seule acquisition du signal de réponse, cette acquisition durant quelques secondes. De plus, l'utilisation de la somme d'une tension sinusoïdale et d'une impulsion de tension pour exciter l'oscillateur permet de s'affranchir d'une éventuelle dérive de la fréquence de résonance tout en générant une force d'actionnement électrostatique suffisante pour mettre en résonance l'oscillateur. Dans ce cas, il n'est pas nécessaire de connaître précisément la fréquence de résonance de l'oscillateur.

Selon un mode de mise en œuvre, l'étape de détermination du facteur de qualité comporte les opérations suivantes :

- obtenir, par transformation dans le domaine fréquentiel, une densité spectrale d'amplitude de la tension de réponse, la densité spectrale d'amplitude présentant un pic de résonance ;
- filtrer la densité spectrale d'amplitude autour de la fréquence de résonance ;
- effectuer une transformation inverse de la densité spectrale d'amplitude filtrée de manière à obtenir une tension de réponse filtrée dans le domaine temporel ;
- déterminer le facteur de qualité de l'oscillateur par une mesure du décrément logarithmique de l'amplitude des oscillations de la tension de réponse filtrée.

Selon un mode de mise en œuvre, l'étape de détermination du facteur de qualité comporte les opérations suivantes :

- obtenir, par transformation dans le domaine fréquentiel, une densité spectrale d'amplitude de la tension de réponse, la densité spectrale d'amplitude présentant un pic de résonance ;
- déterminer le facteur de qualité de l'oscillateur en calculant le rapport entre la fréquence de résonance et la largeur du pic de résonance considérée à la moitié de sa hauteur.

Selon un mode de mise en œuvre, le procédé comporte une étape préalable d'estimation de la fréquence de résonance de l'oscillateur, la tension sinusoïdale présentant une fréquence égale à la fréquence de résonance estimée.
Selon un mode de mise en œuvre, l'impulsion de tension est une réponse impulsionnelle d'un filtre passe-bas.
Selon un mode de mise en œuvre, l'impulsion de tension se présente sous la forme d'une fonction sinus cardinal.
Un deuxième aspect de l'invention concerne un produit programme d'ordinateur comprenant des instructions pour la mise en œuvre du procédé selon le premier aspect de l'invention, lorsque ces instructions sont exécutées par un processeur.

## BREVE DESCRIPTION DES FIGURES

L'invention et ses différentes applications seront mieux comprises à la lecture de la description qui suit et à l'examen des figures qui l'accompagnent, parmi lesquelles :

- la figure 1 représente la densité spectrale d'amplitude de la tension de réponse présente en sortie de trois oscillateurs ayant un facteur de qualité respectivement égal à $10^4$, $10^5$ et $10^6$ ;
- la figure 2A représente la variation d'amplitude en fonction du temps de deux impulsions de tension ayant une largeur spectrale respectivement égale à 100 Hz et 10 Hz ;
- la figure 2B représente la densité spectrale d'amplitude des impulsions de tension de la figure 2A ;
- la figure 3 représente la densité spectrale d'amplitude d'une tension d'excitation appliquée en entrée d'un oscillateur, selon un mode de mise en œuvre préférentiel du procédé de l'invention ;
- la figure 4 représente la densité spectrale d'amplitude de la force d'excitation produite par la tension d'excitation de la figure 3 ;
- la figure 5 représente un exemple de tension de réponse d'un oscillateur acquise au moyen du procédé de l'invention ;
- la figure 6 représente la densité spectrale d'amplitude de la tension de réponse de la figure 5, non filtrée et filtrée autour de la résonance ;
- la figure 7 représente la transformée inverse de la densité spectrale d'amplitude filtrée de la figure 6 ;
- la figure 8 représente le décrément logarithmique de l'amplitude des oscillations du signal de la figure 7 ;
- la figure 9 représente deux tensions d'excitation utilisées pour mesurer le facteur de qualité d'un oscillateur, respectivement selon l'art antérieur et selon l'invention ;
- la figure 10 représente la densité spectrale d'amplitude des tensions d'excitation de la figure 9 ;

- la figure 11A représente la densité spectrale d'amplitude des forces d'excitations générées par les tensions d'excitation de la figure 9 ;
- la figure 11B est une vue agrandie de la figure 11A autour de la fréquence de résonance ;

Les figures ne sont présentées qu'à titre indicatif et nullement limitatif de l'invention.

Pour plus de clarté, les éléments identiques ou similaires sont repérés par des signes de référence identiques sur toutes les figures.

## DESCRIPTION DETAILLEE DE MODES DE MISE EN OEUVRE DE L'INVENTION

Un oscillateur de type MEMS ou NEMS comporte une partie fixe et un élément mobile par rapport à la partie fixe. L'oscillateur comporte également une entrée et une sortie entre lesquelles est disposé l'élément mobile.

L'entrée de l'oscillateur est pourvue de moyens d'actionnement électrostatiques configurés pour mettre en vibration l'élément mobile. Les moyens d'actionnement transforment un signal électrique d'entrée, également appelé « signal d'excitation », appliqué en entrée de l'oscillateur en une force d'actionnement électrostatique, également appelée « force d'excitation », agissant sur l'élément mobile. Le signal d'excitation se présente par exemple sous la forme d'une tension. La force d'excitation entraîne des déplacements oscillatoires de l'élément mobile. Les moyens d'actionnement comprennent par exemple une première électrode fixe appartenant à la partie fixe et une première électrode mobile appartenant à l'élément mobile. Ces électrodes peuvent chacune avoir la forme d'un peigne et former ensemble une structure à peignes capacitifs interdigités.

La sortie de l'oscillateur est pourvue de moyens de détection des déplacements de l'élément mobile. Les moyens de détections sont configurés pour délivrer un signal électrique de sortie, également appelé « signal de réponse », qui dépend des déplacements détectés de l'élément mobile. Par exemple, les moyens de détection sont de type capacitif et comportent des moyens de mesure de capacité entre une deuxième électrode fixe appartenant à la partie fixe et une deuxième électrode mobile appartenant à l'élément mobile. Ces électrodes peuvent chacune avoir la forme d'un peigne et former ensemble une structure à peignes capacitifs interdigités.

L'oscillateur est caractérisé par une fréquence de résonance et un facteur de qualité. Ces deux paramètres sont essentiels pour valider la conception de l'oscillateur et pour son intégration dans un dispositif tel qu'un capteur inertiel, par exemple un accéléromètre ou un gyromètre.

Lorsque l'oscillateur est excité à la fréquence de résonance, l'amplitude des oscillations de l'élément mobile est maximale. Lorsque le signal d'excitation n'est plus appliqué, les oscillations de l'élément mobile s'amortissent jusqu'à ce que l'élément mobile retrouve une position de repos dans laquelle l'élément mobile cesse de se mouvoir. L'amortissement dans le temps t des oscillations dépend d'un terme exponentiel $e^{-\frac{t}{2\tau}}$ où $\tau$ est une constante d'amortissement, ou temps de relaxation, définissant la vitesse avec laquelle l'amplitude des oscillations décroît après excitation.

Le facteur de qualité Q de l'oscillateur est défini par la relation suivante :

$$Q = \pi . F_R . \tau$$

où $F_R$ est la fréquence de résonance de l'oscillateur. Le facteur de qualité traduit notamment la précision du capteur dans lequel l'oscillateur est intégré. Plus le facteur de qualité est élevé, plus la précision l'est aussi.

La présente invention a pour objectif principal de proposer un procédé de détermination du facteur de qualité de l'oscillateur, ce procédé étant à la fois rapide et fiable.

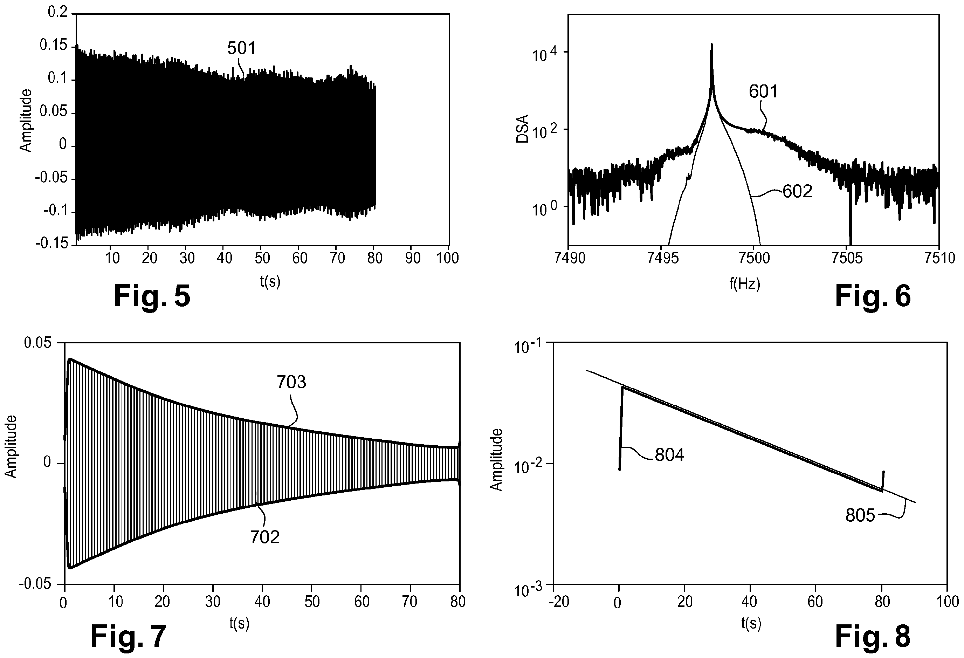

Un mode de mise en œuvre préférentielle du procédé selon l'invention va maintenant être décrit, en référence aux figures 5 à 8. Le procédé comporte une étape de génération d'une tension d'excitation. La tension d'excitation est par exemple fournie par un générateur de signal connecté électriquement à l'entrée de l'oscillateur. Selon ce mode de mise en œuvre préférentielle, la tension d'excitation est la somme d'une tension sinusoïdale de fréquence $F_0$ constante et d'une réponse impulsionnelle finie d'un filtre passe-bas. La réponse impulsionnelle a de préférence la forme d'une fonction sinus cardinal de largeur spectrale $\Delta F$, la tension d'excitation u(t) pouvant alors être définie par l'équation suivante :

$$u(t) = A . \mathrm{sinc}(\Delta F . t) + B . \sin(2 . \pi . F_0 . t) \qquad (2)$$

où A et B sont l'amplitude respectivement du sinus cardinal et de la tension sinusoïdale.

Alternativement, la réponse impulsionnelle peut être celle de tout type de filtre passe-bas tel qu'une fenêtre de Hamming, de Hanning, de Tchebychev, de Bartlett, ou de Blackman.

La figure 3 représente schématiquement la densité spectrale d'amplitude 300 de la tension d'excitation u(t), par exemple calculée au moyen d'une transformée de Fourier. Une densité spectrale d'amplitude est exprimée en unité par racine de hertz, c'est-à-dire en volt par racine de hertz (V.Hz$^{-0,5}$) lorsqu'il s'agit de la densité spectrale d'amplitude d'une tension d'excitation, et en newton par racine de hertz (N.Hz$^{-0,5}$) lorsqu'il s'agit de la densité spectrale d'amplitude d'une force d'excitation.

La densité spectrale d'amplitude 300 de la tension d'excitation comporte :

- une première composante 301 correspondant à la densité spectrale du sinus cardinal, la première composante 301 étant une fonction porte centrée sur 0 Hz et de largeur spectrale $\Delta F$ ;
- une deuxième composante 302 correspondant à la densité spectrale de la tension sinusoïdale, la deuxième composante 302 étant un pic de Dirac situé à la fréquence $F_0$.

La tension d'excitation est appliquée en entrée de l'oscillateur pour le mettre en oscillation. La force d'excitation qui en résulte est proportionnelle au carré de la tension d'excitation. La force d'excitation F(t) peut ainsi être exprimée par l'équation suivante :

$$F(t) = k\left[A^2.\operatorname{sinc}^2(\Delta F.t) + \frac{B^2}{2} - \frac{B^2}{2}.\cos(4.\pi.F_0.t) + \right.$$
$$\left. 2.A.B.\operatorname{sinc}(\Delta F.t).\sin(2.\pi.F_0.t)\right] \qquad (3)$$

où k est un coefficient de proportionnalité. La force d'excitation est donc la somme d'un premier terme proportionnel au carré du sinus cardinal, d'un deuxième terme égal à une constante, d'un troisième terme proportionnel à une fonction sinusoïdale de fréquence $2F_0$, et d'un quatrième terme proportionnel au sinus cardinal modulé à la fréquence $F_0$.

La figure 4 représente schématiquement la densité spectrale d'amplitude 400 de la force d'excitation F(t) obtenue par transformation dans le domaine fréquentiel, par exemple au moyen d'une transformée de Fourier. La densité spectrale d'amplitude 400 comprend :

- une première composante 401 correspondant à la densité spectrale d'amplitude du premier terme de l'équation (3), la première composante 401 ayant une forme triangulaire centrée sur 0 Hz et de largeur spectrale $2\Delta F$ ;
- une deuxième composante 402 correspondant à la densité spectrale d'amplitude du deuxième terme de l'équation (3), la deuxième composante 402 étant un pic de Dirac situé à 0 Hz ;
- une troisième composante 403 correspondant à la densité spectrale d'amplitude du troisième terme de l'équation (3), la troisième composante 403 étant un pic de Dirac situé à la fréquence 2Fo ;
- une quatrième composante 404 correspondant à la densité spectrale d'amplitude du quatrième terme de l'équation (3), la quatrième composante 404 étant une fonction porte centrée sur la fréquence $F_0$ et de largeur spectrale $\Delta F$.

La largeur spectrale $\Delta F$ du sinus cardinal et la fréquence $F_0$ de la tension sinusoïdale sont paramétrées de manière à ce que la quatrième composante 404 de la force d'excitation F(t) s'étende sur une plage de fréquence incluant la fréquence de résonance de l'oscillateur. En d'autres termes, la largeur spectrale $\Delta F$ du sinus cardinal et la fréquence $F_0$ de la tension sinusoïdale sont liées par la relation suivante :

$$F_0 - \frac{\Delta F}{2} \leq F_R \leq F_0 + \frac{\Delta F}{2}$$

La tension d'excitation est appliquée en entrée de l'oscillateur pendant une durée suffisante pour décrire l'impulsion de tension. Dans le cas par exemple où l'impulsion de tension est un sinus cardinal, cette durée est au moins égale à $2/\Delta F$ de manière à définir au moins le premier lobe de la fonction sinus cardinale.

L'alimentation électrique de l'oscillateur est ensuite coupée. On arrête d'exciter l'oscillateur. Une fois qu'on a cessé d'appliquer la tension d'excitation en entrée de l'oscillateur, on procède à une étape d'acquisition dans le domaine temporel du signal de réponse de l'oscillateur fourni par les moyens de détection. Pour ce faire, des moyens d'acquisitions sont connectés électriquement à la sortie de l'oscillateur. Les moyens d'acquisition peuvent être une carte électronique d'acquisition ou un oscilloscope numérique. Le signal de réponse se présente par exemple sous la forme d'une tension.

L'acquisition est effectuée avec une fréquence d'échantillonnage configurée pour respecter le critère de Shannon. La fréquence d'échantillonnage dépend ici de la fréquence $F_0$ de la tension sinusoïdale et de la largeur spectrale $\Delta F$ de la réponse impulsionnelle, la fréquence d'échantillonnage $F_e$ devant respecter l'inégalité suivante :

$$F_e \geq 2.\left(F_0 + \frac{\Delta F}{2}\right)$$

La figure 5 montre un exemple de la tension réponse 501 acquise en sortie d'un oscillateur dont la fréquence de résonance est connue et est approximativement égale à 7,5 kHz. Dans cet exemple, la fréquence $F_0$ de la tension sinusoïdale est donc fixée à 7,5 kHz et la largeur spectrale $\Delta F$ du sinus cardinal est réglée à 8 Hz.

Le facteur de qualité de l'oscillateur peut être déterminé à partir de la tension de réponse 501 ainsi acquise, par exemple par une mesure du décrément logarithmique de l'amplitude des oscillations de la tension de réponse 501. Il s'agit en d'autres termes de mesurer la vitesse avec laquelle l'amplitude des oscillations décroît. Pour ce faire, la tension de réponse 501 est de préférence transformée dans le domaine fréquentiel pour obtenir sa densité spectrale d'amplitude 601, comme illustré à la figure 6. La densité spectrale d'amplitude 601 de la tension de réponse 501 est par exemple calculée au moyen d'une transformée de Fourier.

La tension de réponse 501 étant affectée par du bruit, on procède avantageusement à une étape de filtrage de la densité spectrale d'amplitude 601 autour de la fréquence de résonance de manière à obtenir une densité spectrale d'amplitude filtrée 602. L'étape de filtrage est par exemple effectuée au moyen d'un filtre numérique.

Une transformée inverse de la densité spectrale d'amplitude filtrée 602 peut ensuite être effectuée pour repasser dans le domaine temporel et obtenir une tension de réponse filtrée 702, comme illustré à la figure 7. L'amplitude des oscillations de la tension de réponse filtrée 702 décroît avec le temps en fonction du terme exponentiel $e^{-\frac{t}{2\tau}}$. Les oscillations forme une enveloppe 703 de la tension de réponse filtré 702.

La figure 8 montre une première courbe 804 représentant le décrément logarithmique de l'amplitude des oscillations dans un repère semi-logarithmique. La première courbe 804 est par exemple obtenue en effectuant une détection d'amplitude sur la tension de réponse filtrée 702. La figure 8 montre également une deuxième courbe 805 qui représente une approximation du décrément logarithmique à partir de laquelle on détermine la constante d'amortissement $\tau$. En connaissant la fréquence de résonance de l'oscillateur, le facteur de qualité peut être calculé à partir de la relation liant le facteur de qualité à la constante d'amortissement. Dans cet exemple, la constante d'amortissement $\tau$ est approximativement égale à 40,4 s et le facteur de qualité Q est approximativement égal à 951903.

Grâce à l'invention, il n'est pas nécessaire de connaître précisément la fréquence de résonance de l'oscillateur. En paramétrant de manière appropriée la fréquence $F_0$ de la tension sinusoïdale et la largeur spectrale $\Delta F$ du sinus cardinal, il est possible de compenser une dérive de la fréquence de résonance de l'oscillateur tout en ayant une densité spectrale d'amplitude suffisante pour que les oscillations se distinguent du bruit et permettre ainsi de mesurer le décrément logarithmique.

Selon un autre mode de mise en œuvre, le facteur de qualité est déterminé en calculant, à partir de la densité spectrale d'amplitude 601 de la tension de réponse 501, le rapport de la fréquence de résonance sur la largeur du pic de résonance considérée à la moitié de sa hauteur.

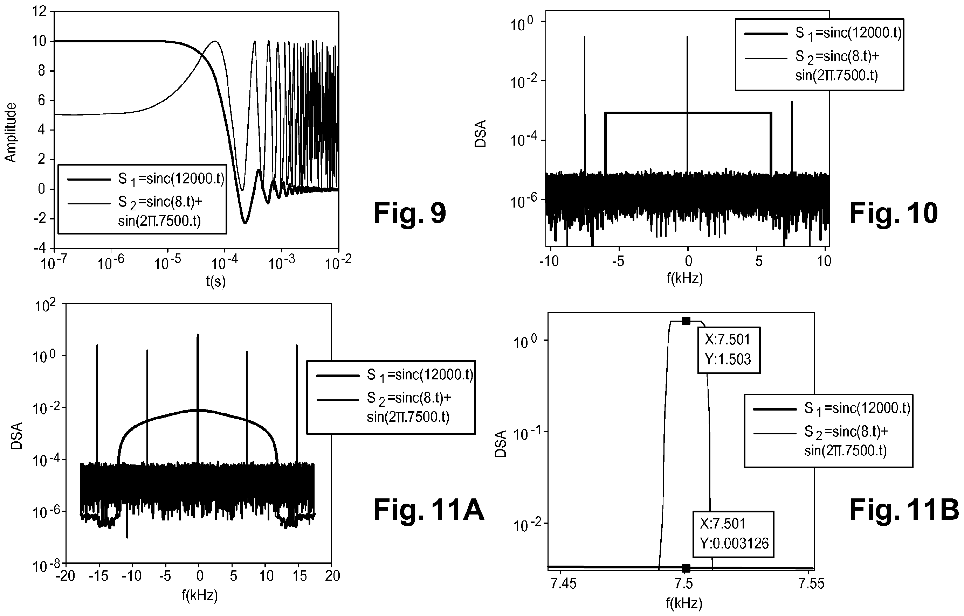

Les figures 9 à 11B illustrent une comparaison entre l'utilisation d'une première tension d'excitation $S_1$ selon l'art antérieure et l'utilisation d'une deuxième tension d'excitation $S_2$ selon l'invention.

La figure 9 montre la représentation temporelle des tensions d'excitations $S_1$ et $S_2$. La première tension d'excitation $S_1$ se présente sous la forme d'une impulsion de tension, telle qu'une fonction sinus cardinal, et est paramétrée de manière à maximiser la force d'excitation à la fréquence de résonance de l'oscillateur, par exemple égale à 7,5 kHz. L'impulsion de tension $S_1$ est donc définie par l'équation suivante :

$$S_1(t) = \text{sinc}(12000.\,t) \tag{4}$$

La deuxième tension d'excitation $S_2$ est celle utilisée dans l'exemple de mise œuvre décrit en référence aux figures 5 à 8. La deuxième tension d'excitation $S_2$ est donc définie par l'équation suivante :

$$S_2(t) = \text{sinc}(8.\,t) + \sin(2\pi.\,7500.\,t) \tag{5}$$

Les tensions d'excitation $S_1$ et $S_2$ présentent une amplitude maximale normée à 10 V de manière à être représentatives d'un générateur de signaux délivrant une tension maximale limitée à 10 V.

La figure 10 représente la densité spectrale d'amplitude des tensions d'excitation $S_1$ et $S_2$. La densité spectrale d'amplitude de l'impulsion de tension $S_1$ est une fonction porte centrée sur 0 Hz et ayant une largeur spectrale de 12 kHz. La densité spectrale d'amplitude de la deuxième tension d'excitation $S_2$ comporte une fonction porte centrée sur 0 Hz et ayant une largeur spectrale de 8 Hz, et un pic de Dirac correspondant à la tension sinusoïdale et situé à 7,5 kHz.

La figure 11A représente la densité spectrale d'amplitude des forces d'excitations générées par les tensions d'excitation $S_1$ et $S_2$. La densité spectrale d'amplitude de la force d'excitation générée par la première tension d'excitation présente une forme triangulaire centrée sur 0 Hz et ayant une largeur spectrale de 24 kHz. La densité spectrale d'amplitude de la force d'excitation générée par la deuxième tension d'excitation $S_2$ comporte une forme triangulaire centrée sur 0 Hz et ayant une largeur spectrale de 24 kHz.

La figure 11B est un agrandissement de la figure 11A centré autour de la fréquence $F_0$ de la deuxième tension d'excitation $S_2$, qui correspond approximativement à la fréquence de résonance de l'oscillateur. Autour de la fréquence de résonance, la force électrostatique générée par la deuxième tension d'excitation $S_2$ est environ 1000 fois plus élevée que la force électrostatique générée par la première tension d'excitation $S_1$. Par ailleurs, on peut également remarquer que le paramétrage de la fréquence $F_0$ de la deuxième tension d'excitation $S_2$ est environ 1000 fois plus tolérant que dans le cas d'une tension d'excitation sinusoïdale utilisée dans l'art antérieur. Pour cette dernière, il faudrait régler la fréquence avec une précision d'environ $8.10^{-3}$ Hz $\left( \frac{F_R}{Q} \approx \frac{7,5.10^3}{9,5.10^5} \right)$ alors que dans cet exemple, la force d'excitation est constante sur une plage de 8 Hz autour de la fréquence de résonance.

Le procédé selon l'invention est par exemple mis en œuvre par le biais d'une application. Une application désigne un programme d'ordinateur comprenant des instructions exécutables par un processeur.

## Revendications

1. Procédé de détermination d'un facteur de qualité d'un oscillateur à actionnement électrostatique, l'oscillateur présentant une fréquence de résonance ($F_R$), le procédé comportant les étapes suivantes :

   - estimer la fréquence de résonance, $F_R$, de l'oscillateur ;
   - générer une tension d'excitation, $S_2(t)$, définie comme étant la somme d'une tension sinusoïdale présentant une fréquence constante, $F_0$, égale à la fréquence de résonance estimée et d'une réponse impulsionnelle finie d'un filtre passe-bas présentant une largeur spectrale, $\Delta F$, la fréquence constante, $F_0$, et la largeur spectrale, $\Delta F$, étant paramétrées de façon à satisfaire la relation suivante :

$$F_0 - \frac{\Delta F}{2} \leq F_R \leq F_0 + \frac{\Delta F}{2}$$

   où $F_R$ est la fréquence de résonance de l'oscillateur ;
   - appliquer la tension d'excitation en entrée de l'oscillateur ;
   - acquérir dans le domaine temporel une tension de réponse (501) présente en sortie de l'oscillateur après avoir cessé d'appliquer la tension d'excitation en entrée de l'oscillateur ;
   - déterminer le facteur de qualité de l'oscillateur à partir de la tension de réponse (501) acquise en sortie de l'oscillateur.

2. Procédé selon la revendication 1, dans lequel l'étape de détermination du facteur de qualité comporte les opérations suivantes :

   - obtenir, par transformation dans le domaine fréquentiel, une densité spectrale d'amplitude (601) de la tension de réponse (501), la densité spectrale d'amplitude (601) présentant un pic de résonance ;
   - filtrer la densité spectrale d'amplitude (601) autour de la fréquence de résonance ;
   - effectuer une transformation inverse de la densité spectrale d'amplitude filtrée (602) de manière à obtenir une tension de réponse filtrée (702) dans le domaine temporel ;
   - déterminer le facteur de qualité de l'oscillateur par une mesure du décrément logarithmique de l'amplitude des oscillations de la tension de réponse filtrée (702).

3. Procédé selon la revendication 1, dans lequel l'étape de détermination du facteur de qualité comporte les opérations suivantes :

   - obtenir, par transformation dans le domaine fréquentiel, une densité spectrale d'amplitude (601) de la tension de réponse (501), la densité spectrale d'amplitude (601) présentant un pic de résonance ;

- déterminer le facteur de qualité de l'oscillateur en calculant le rapport entre la fréquence de résonance et la largeur du pic de résonance considérée à la moitié de sa hauteur.

4. Procédé selon la revendication 3, dans lequel la réponse impulsionnelle d'un filtre passe-bas se présente sous la forme d'une fonction sinus cardinal.

5. Produit programme d'ordinateur comprenant des instructions pour la mise en œuvre d'un procédé selon l'une quelconque des revendications 1 à 4, lorsque ces instructions sont exécutées par un processeur.


**Patentansprüche**

1. Verfahren zur Bestimmung eines Qualitätsfaktors eines Oszillators mit elektrostatischer Betätigung, wobei der Oszillator eine Resonanzfrequenz ($F_R$) aufweist, wobei das Verfahren die folgenden Schritte aufweist:

   - Ermitteln der Resonanzfrequenz $F_R$ des Oszillators;
   - Erzeugen einer Erregungsspannung $S_2(t)$, die als die Summe einer Sinusspannung mit einer konstanten Frequenz $F_0$ gleich der ermittelten Resonanzfrequenz und einer endlichen Impulsantwort eines Tiefpassfilters mit einer Spektralbreite $\Delta F$ definiert ist, wobei die konstante Frequenz $F_0$ und die Spektralbreite $\Delta F$ derart parametriert sind, dass die der folgenden Gleichung entsprechen:

$$F_0 - \frac{\Delta F}{2} \leq F_R \leq F_0 + \frac{\Delta F}{2}$$

   wobei $F_R$ die Resonanzfrequenz des Oszillators ist;
   - Anwenden der Erregungsspannung am Eingang des Oszillators;
   - Erlangen im Zeitbereich einer Antwortspannung (501), die am Ausgang des Oszillators vorhanden ist, nach Beendigung der Anwendung der Erregungsspannung am Eingang des Oszillators;
   - Bestimmen des Qualitätsfaktors des Oszillators ausgehend von der erlangten Antwortspannung (501) am Ausgang des Oszillators.

2. Verfahren nach Anspruch 1, wobei der Schritt des Bestimmens des Qualitätsfaktors die folgenden Operationen aufweist:

   - Erhalten, durch Transformation im Frequenzbereich, einer Amplitudenspektraldichte (601) der Antwortspannung (501), wobei die Amplitudenspektraldichte (601) eine Resonanzspitze aufweist;
   - Filtern der Amplitudenspektraldichte (601) um die Resonanzfrequenz;
   - Durchführen einer inversen Transformation der gefilterten Amplitudenspektraldichte (602) derart, dass eine gefilterte Antwortspannung (702) im Zeitbereich erhalten wird;
   - Bestimmen des Qualitätsfaktors des Oszillators durch eine Messung des logarithmischen Dekrements der Amplitude der Oszillationen der gefilterten Antwortspannung (702).

3. Verfahren nach Anspruch 1, wobei der Bestimmungsschritt des Qualitätsfaktors die folgenden Operationen aufweist:

   - Erhalten, durch Transformation im Frequenzbereich, einer Amplitudenspektraldichte (601) der Antwortspannung (501), wobei die Amplitudenspektraldichte (601) eine Resonanzspitze aufweist;
   - Bestimmen des Qualitätsfaktors des Oszillators durch Berechnen des Verhältnisses zwischen der Resonanzfrequenz und der Breite der Resonanzspitze, die auf der Hälfte ihrer Höhe berücksichtigt wird.

4. Verfahren nach Anspruch 3, wobei die Impulsantwort eines Tiefpassfilters in Form einer Kardinalsinusfunktion vorliegt.

5. Rechnerprogrammprodukt, umfassend Instruktionen für die Durchführung eines Verfahrens nach einem der Ansprüche 1 bis 4, wenn diese Instruktionen von einem Prozessor ausgeführt werden.

**Claims**

1.  Method for determining a quality factor of an electrostatically actuated oscillator, the oscillator having a resonance frequency ($F_R$), the method comprising the following steps:

    - estimating the resonance frequency, $F_R$, of the oscillator;
    - generating an excitation voltage, $S_2(t)$, defined as being the sum of a sinusoidal voltage having a constant frequency, $F_0$, equal to the estimated resonance frequency and a finite pulse response of a low-pass filter having a spectral width, $\Delta F$, the constant frequency, $F_0$, and the spectral width, $\Delta F$, being parameterised so as to satisfy the following relationship:

$$F_0 - \frac{\Delta F}{2} \leq F_R \leq F_0 + \frac{\Delta F}{2}$$

    where $F_R$ is the resonance frequency of the oscillator;
    - applying the excitation voltage at the input of the oscillator;
    - acquiring in the time domain a response voltage (501) present at the output of the oscillator after having ceased applying the excitation voltage at the input of the oscillator;
    - determining the quality factor of the oscillator from the response voltage (501) acquired at the output of the oscillator.

2.  Method according to the claim 1, wherein the step of determining the quality factor comprises the following operations:

    - obtaining, by transformation in the frequency domain, an amplitude spectral density (601) of the response voltage (501), the amplitude spectral density (601) having a resonance peak;
    - filtering the amplitude spectral density (601) around the resonance frequency;
    - carrying out an inverse transformation of the filtered amplitude spectral density (602) so as to obtain a filtered response voltage (702) in the time domain;
    - determining the quality factor of the oscillator by measuring the logarithmic decrement of the amplitude of the oscillations of the filtered response voltage (702).

3.  Method according to the claim 1, wherein the step of determining the quality factor comprises the following operations:

    - obtaining, by transformation in the frequency domain, an amplitude spectral density (601) of the response voltage (501), the amplitude spectral density (601) having a resonance peak;
    - determining the quality factor of the oscillator by calculating the ratio between the resonance frequency and the width of the resonance peak considered at half of its height.

4.  Method according to claim 3, wherein the pulse response of a low-pass filter is in the form of a cardinal sine function.

5.  Computer programme product including instructions for the implementation of a method according to any of claims 1 to 4, when these instructions are executed by a processor.

Fig. 1

Fig. 2A

**Fig. 2B**

**Fig. 3**

**Fig. 4**

Fig. 5

Fig. 6

Fig. 7

Fig. 8

13

Fig. 9

Fig. 10

Fig. 11A

Fig. 11B

EP 3 462 188 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **WEN-MING ZHANG et al.** Nonlinear Dynamic Analysis of Electrostatically Actuated Resonant MEMS Sensors Under Parametric Excitation. *IEEE Sensors Journal,* 01 Mars 2007, vol. 7 (3), 370-380